# EUROPEAN PATENT APPLICATION

(11) **EP 2 091 093 A1**
(43) Date of publication of application: **19.08.2009**
(21) Application number: 07848127.2
(22) Date of filing: 13.11.2007
(51) Int. Cl.: H01L 51/00, B05D 5/12

(54) **ORGANIC SENSOR DEVICE AND ITS APPLICATIONS**

(30) Priority: 14.11.2006 ES 200602887
(71) Applicant: Consejo Superior De Investigaciones Científicases, 28006 Madrid (ES); Institució Catalana de Recerca i Estudis Avançats, 08010 Barcelona (ES)
(72) Inventor: LAUKHINA, Elena, 08193 Bellaterra (ES); MAS TORRENT, Marta, 08193 Bellaterra (ES); ROVIRA ANGULO, Concepció, 08193 Bellaterra (ES); VECIANA MIRÓ, Jaume, 08193 Bellaterra (ES); LAUKHIN, Vladimir, 08193 Bellaterra (ES)
(74) Representative: Pons Arino, Angel
(86) International application number: PCT/ES2007/070184
(87) International publication number: WO 2008/059095

(57) **Abstract**

The invention is **characterised in that** it consists of a layer of material formed of at least one conductive salt or complex including a molecule A and a dopant D, said molecule A being an organic molecule or macromolecule selected from among a coronene, tetrathiafulvalene or tetracyanoquinodimethane derivative; and a base substrate, in close contact with said layer of organic material, wherein said base substrate is inert with respect to said layer of organic material, and having the capacity to detect pressure and/or temperature changes.

The sensor device is of application in molecular electronics or plastic electronics and, in particular, in the field of organic sensors, especially in the manufacturing of breathing masks, in medical devices in general, motoring, clothing or textiles and intelligent footwear.

## Description

### SECTOR OF THE ART

The present invention relates to an organic sensor device sensitive to changes in pressure, voltage, deformation and/or temperature.

The organic sensor device of the present invention comprises a layer of organic material in close contact with a base substrate.

The sensor device of the invention is applicable in molecular electronics or plastic electronics and, in particular, in the field of organic sensors.

### STATE OF THE ART

A sensor has the purpose of providing physical, chemical or biological information on our environment.

The materials traditionally used as sensors are based on inorganic compounds, semiconductors, electrolytes, metals and catalytical materials.

However, at present there is a growing need to manufacture gas, temperature and pressure sensors at low costs and with additional features. This requires the use of less components and manufacturing processes and cheaper or new materials. Additionally, for some applications size and weight limitations can also be of great importance.

In order to achieve these objectives, the use of organic materials in sensors offer clear advantages due to their low cost, processability, flexibility, low weight and the possibility of modulating their properties by means of chemical synthesis.

Insulating organic and intrinsically conductive polymers have been used in sensor preparation. Typically, intrinsically conductive polymers are used as a coating material or to encapsulate an electrode, and non-conductive polymers are used to immobilise the receptive agents of the device (see for example B. Adhikari and S.Majumdar, Prog. Polym. Sci. 29 (2004) 699).

International Patent WO 9303355 describes a method for manufacturing a gas sensor from a semi-conductive polymer. This polymer is capable of reacting with gases and volatile compounds and, when this occurs, polymer resistance is modified. In this manner, the sensor can be used to detect the presence of gases in the atmosphere by measuring polymer resistance between two contacts. However, this method requires a large number of steps (approximately 20).

A typical example of an organic sensor based on interdigitated electrodes and a piezoelectric polymer is described in Patent WO 2006057987. The electrodes are disposed on the polymer so that pressure data may be detected and transmitted.

One of the main difficulties in designing and manufacturing polymer-based sensors is to produce the electrical contacts with the polymeric materials. Microelectronic techniques allow the manufacture of high-precision electrodes; nevertheless, said techniques give rise to electrical contacts with resistances comparable to or greater than the intrinsic resistance of the polymer, which leads to inaccurate measurements. On the other hand, another difficulty of the polymeric sensors is due to the fact that the resistance temperature coefficients (CTR) of many polymers are very high and, consequently, it is often necessary to use temperature compensation techniques that increase final sensor cost. Another difficulty of these devices is that the polymers are normally synthesized by electrochemical means. Therefore, it is necessary to use electrochemical equipment and manufacture metallic electrodes, typically made of gold or platinum. The adhesion of the polymer to the substrate can also be a problem, in addition to the area of the device that is limited by the separation of the electrodes. Additionally, the polymeric organic sensors tend to become easily degraded.

Sensors with organic transistors have also been manufactured (see T. Someya, T. Sekitani, S. Iba, Y. Kato, H. Kawaguchi, T. Sakurai, PNAS 2004, 101, 9966), but in order to prepare these types of devices many different stages are also required.

Therefore, there is a pressing need to find new accurate and low-cost orgnanic sensors.

Among molecular conductive materials, transfer salt crystals are highly promising because their conductivity at ambient temperature is very sensitive to pressure changes and their conductivity typically increases linearly with temperature. Most of these molecular crystals are metals or semiconductors with very low activation energy and, therefore, their CTRs are lower than those of the organic polymers. Organic conductors are softer than metals and inorganic semiconductors and, for this reason, the piezoresistivity values of molecular conductors are greater than those of traditional conductors. For example, at 8 Kbar the conductivity of the molecular superconductor β-(ET)₂I₃ [ET = bis(ethylenedithio)tetrathiafulvalene] is an order of magnitude greater than at ambient pressure.

On the other hand, Patent SU 1668855 describes the effect of applying voltage to β-(ET)₂|₃ crystals.

R. Lyiubovskii and collaborators in Synthetic Metals, 40 (1991) 155 also described a high increase in conductivity upon applying pressure to β-(PT)₂I₃ [PT = bis(propylenedithio)tetrathiafulvalene] crystals; for example, at 80 Kbar of pressure, conductivity increased by a factor of 1300.

Additionally, it is also well known that conductivity in conductive organic salt crystals, typically based on tetrathiafulvalene derivatives, have different types of response to temperature. See, for example, J. M. Williams, J. R. Ferraro, R. J. Thorn, K. D. Carlson, U. Geiser, H. H. Wang, A. M. Kini, M.-H. Whangbo, Organic Superconductors (Including Fullerenes): Synthesis, Structure, Properties, and Theory, Prentice Hall, Englewood Cliffs, New Jersey, 1992.

Additionally, humidity-sensitive conductivity in crystals and in a microcrystalline layer of (BEDO-TTF)₂Br(H₂O)₃ [BEDO-TTF = bis(ethylenedioxo-tetrathiafulvalene] has been recently described (see H. Yamochi et al. J. Phys. IV France, 114 (2004) 591). Unfortunately, the results vary widely from one sample to another.

However, the sensory properties of molecular crystals do not translate into immediate applications. The fragility of molecular crystals makes them inadequate for the manufacture of electronic devices and, consequently, alternative solutions must be found.

### DESCRIPTION OF THE INVENTION

### Brief Description

A first aspect of the present invention is to provide an organic sensor device being low in cost and having high processability and flexibility, low weight and the possibility of modulating its properties by means of chemical synthesis.

In accordance with the first aspect of the invention, an organic sensor device is provided, as defined in claim 1.

A second aspect of the invention is the use of said organic material, as defined in claim 14.

In the present invention, the term "sensitive to changes in pressure, voltage, deformation, ambient gases and/or temperature" is understood to mean the capacity of the organic material to detect changes in pressure due to a force applied directly to, at least, a part of the surface of the organic material such as a voltage, deformation, shearing or pressure exerted by a fluid, and/or the capacity of the organic material to detect changes in temperature. In the present invention, the term "sensory" has also been used with the same meaning.

### Detailed Description

The use of molecular conductor-based sensors eliminates many of the problems associated to polymer-based organic sensors, as the layer of molecular conductors can be prepared in any type of substrate and without using electrochemical methods.

The resistance of the sensors prepared in the present invention reveals a high piezosensitivity effect within a pressure range of 0-100 mbar (K=45%), which can be of great interest to medical applications (Table 1).

Additionally, the data presented also reveal that the sensors prepared in the present invention are temperature-sensitive, especially within a temperature range of 25-65°C, which can be of great interest to medical and biomedical applications (Table 3).

Therefore, the present invention provides an organic sensor device, as defined in claim 1.

Advantageously, said molecule or macromolecule A will be selected from among an acene, coronene, tetrathiafulvalene or tetracyanoquinodimethane derivative, preferring bis(ethylenthio)tetrathiafulvalene (BET-TTF) or bis(ethylendithio)tetrathiafulvalene (BEDT-TTF).

Preferably, said dopant D is a volatile species, being a volatile species advantageously selected from among iodine, bromine, iodine bromide, chlorine or iodine chloride.

Also preferably, said salt is selected from among BEDT-TTF)₂I₃ and (BET-TTF)₂IₓBr₃₋ₓ, where BET-TTF is bis(ethylenthio)tetrathiafulvalene and BEDT-TTF is bis(etylendithio)tetrathiafulvalene.

Said base substrate must be inert with respect to the organic layer sensitive to changes in pressure, voltage, deformation, gases or temperature, which may be inorganic such as, for example, silicium oxide or aluminium oxide, metallic, polymeric or a three-dimensional crystal.

Preferably, said base substrate is a non-conductive organic polymer. More preferably, the substrate shall be a thermoplastic polymer or elastomer. Even more preferably, it shall be selected from among polycarbonate, polymethylmetacrilate, polyethylene or polypropylene.

For applications as a pressure sensor the substrate shall preferably have a high resistance to cyclic mechanical loading and shall be difficult to break under load application. For this application an organic layer sensitive to changes in pressure, deformation, voltage or gases formed by a material with a high piezoresistivity and low temperature resistance coefficient shall also be preferable, preferring (BEDT-TTF)₂I₃ as the organic layer.

For applications as a temperature sensor the substrate shall preferably not be degraded as a consequence of temperature changes and the layer of organic material shall preferably be (BET-TTF)₂IₓBr₃₋ₓ.

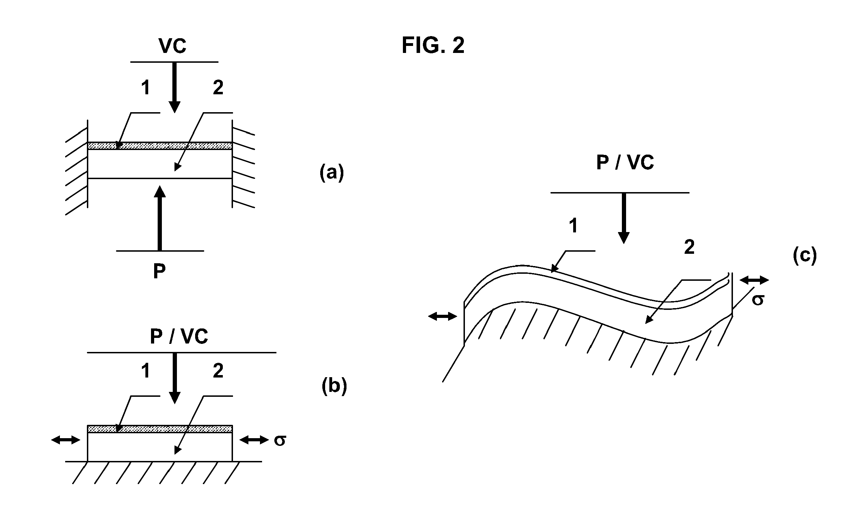

The final result is, therefore, the attainment of a layer of material of organic nature having different conductive surface properties that are modified by changes in temperature or through the application of pressure, voltage or deformations. The shape, configuration or thickness of the sensory organic layer or substrate is not limited herein. Preferably, a diaphragm-type configuration as shown in Figure 2 shall be used. The sensory organic layer will act as an electric signal sensing and transductive material.

In order to transduce the data, patterns, circuits or devices (for example, resistors, condensers, transistors, etc.) may be designed in the same sensory organic layer using the technique described in Patent Application ES 200501879, a summary of which is included below (see Figure 3). In this manner, the change-sensitive organic layer may also act as a circuit.

Patent Application ES 200501879 describes a method for obtaining patterns on a conductive organic layer consisting of:
exposing a conductive organic layer to a heat source,
where said conductive organic layer is formed of a salt or conductive complex including a molecule A and a dopant D, said molecule A being an electron donor or acceptor organic molecule or macromolecule capable of forming a conductive salt or complex, and said dopant D being an electron acceptor or donor, preferably volatile, capable of forming a salt or conductive complex with the molecule or macromolecule A,
in such a manner that a thermal reaction takes place which modifies the chemical composition of said organic layer, leaving areas exempt from dopant D in accordance with the following reaction:

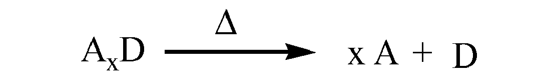

Optionally, the heat source may be applied locally to the conductive organic layer following a pattern designed at millimetric, micrometric or nanometric scale, or in general over the whole surface through the use of thermally insulating intermediate masks having the specific previously designed pattern.

Optionally, a mask may also be used on the organic layer that is heated, in such a manner that the thermal reaction takes place on the part of the mask in contact with the organic layer.

However, other types of electric contacts may also be used.

Said organic layer sensitive to changes in pressure and temperature may be formed of crystals, fibres or other structures. The structure or morphology of the layer does not form part of the present invention, although advantageously, the layers formed by nanocrystals shall be interesting for obtaining transparency and flexibility.

The sensory organic layer may also contain metallic or conductive particles or other additive compounds.

Providing a method for obtaining said sensory organic layer over a base substrate does not form part of the object of the present invention. However, advantageously, the method described in Patent EP 19840109489, 19840809 or in E. Laukhina et al. Synthetic Metals 70 (1995) 795 shall be used, due to the fact that it is a very simple and inexpensive method that allows the sensory organic layer to be prepared directly over a polymeric base substrate. The sensory organic layer may also be prepared by other methods, such as by direct evaporation of the salt or AD complex or of the precursor A and D compounds on the base substrate, directly giving rise to the sensory organic layer formed by the salt or AD complex.

Advantageously, the organic sensor device to which the present invention relates may be manufactured in polymeric substrates, giving rise to a flexible device that is completely organic, low in weight and transparent.

Also advantageously, said organic sensor device may be manufactured at different scales, including at micro- and nanometric scale.

Advantageously, said organic sensor device may be highly sensitive to changes in pressure, voltage, deformation and/or temperature.

The invention also relates to the use of the organic material defined in the aforementioned layer i) of the organic sensor device, as a sensor element for detecting changes in pressure, voltage, deformation or temperature, regardless of the presence or non-presence of other elements such as a base substrate.

The sensor device of the invention is of application in molecular electronics or plastic electronics and, in particular, in the field of organic sensors. The sensor device according to the present invention is of special interest in breathing masks, medicine in general, motoring, clothes or textiles and intelligent footwear, among other significant uses.

### DESCRIPTION OF THE FIGURES

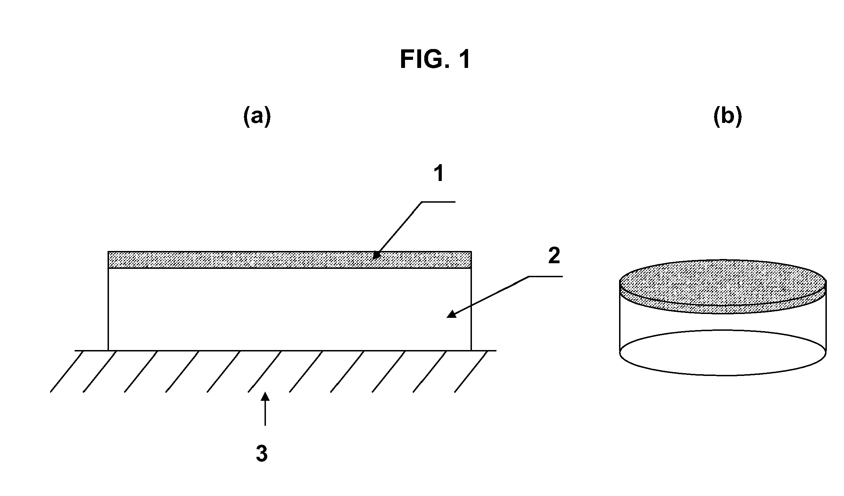

Figure 1 shows an organic sensor device according to the present invention, where a layer of organic material 1, sensitive to changes in pressure, deformation or voltage is in close contact with a base substrate 2. This device is disposed on a glass support 3.
Figure 2 shows a preferred embodiment of the invention where the organic sensor device has a diaphragm-type configuration. The layer of sensory organic material 1 acts as a sensor material (P = pressure, VC = volatile compounds, σ = voltage) and as an electric signal transducer.

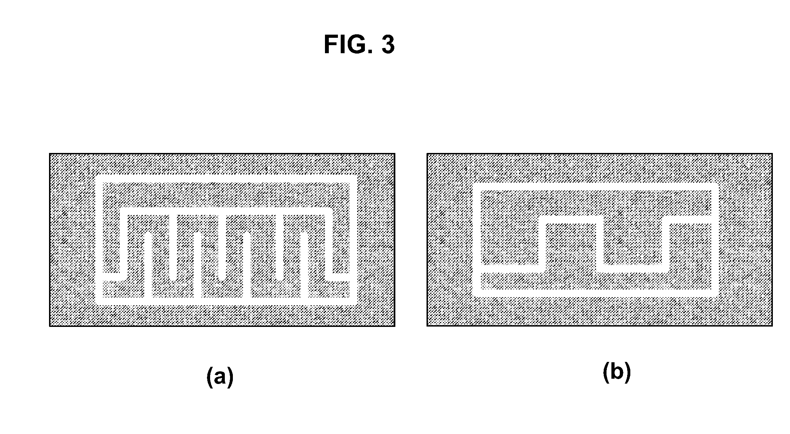

Figure 3 shows a pattern designed in the same layer of sensory organic material using the technique described in Patent Application ES 200501879, a summary of which is included herein.
Figure 4 shows an organic sensor device according to the present invention where (1) indicates the support, (2) the layer of organic material, (3) epoxy resin, (4) a glass tube, (5) two contacts for measuring the current and (6) two contacts for applying voltage. In the Figure, (P) refers to pressure, (G) to gases and (Vap) to organic solvent vapours.
Figure 5 shows the dependence of the resistor with the pressure applied in an organic sensor device formed of (BEDT-TTF)₂I₃ and polycarbonate at an ambient temperature of 35°C. In said figure, we can observe the high piezoelectric effect of the organic sensor device according to an embodiment of the invention.
Figure 6 shows the response of an organic sensor device according to another embodiment of the invention, in particular, the variation in the resistance of an organic sensor device formed of (BEDT-TTF)₂I₃ and polycarbonate in a vacuum (P₀) and in the presence of a combination of gases: CO₂ with methanol and CO₂ with water.
Figure 7 shows the response of the sensory organic material according to another embodiment of the invention, in particular, the variation in the resistance of an organic sensor formed of (BEDT-TTF)₂I₃ and polycarbonate in a vacuum (P₀), and in the presence of O₂, N₂ and He.
Figure 8 shows the response of the sensory organic material according to another embodiment of the invention, in particular, the variation, at ambient pressure, of the resistance with the temperature applied in an organic sensor device formed of (BET-TTF)₂IₓBr₃₋ₓ and polycarbonate.

### EXAMPLES OF EMBODIMENT

### Example 1: Pressure sensing device formed of a layer of (BEDT-TTF)₂I₃ [BEDT-TTF: bis(ethylendithio-tetrathiafulvalene)] over polycarbonate.

A mixture of 0.98 g of poly-(bisphenol-A-carbonate) (PC) and 0.02 g of bis(ethylendithio)-tetrathiafulvalene (BEDT-TTF) was prepared in 50 ml of 1.2-dichlorobenzene and heated at 80°C until the total dissolution thereof. The resulting solution was deposited on a glass surface at 130°C, allowing the solvent to evaporate, thereby obtaining a film having a thickness of 20 microns. Next, the film surface was exposed to the vapours of a dissolution saturated with iodine in methylene chloride for three minutes. This gave rise to the formation of a semiconductive superficial layer having a thickness of 1.5 microns formed by (BEDT-TTF)₂I₃ salt micro- and nanocrystals.

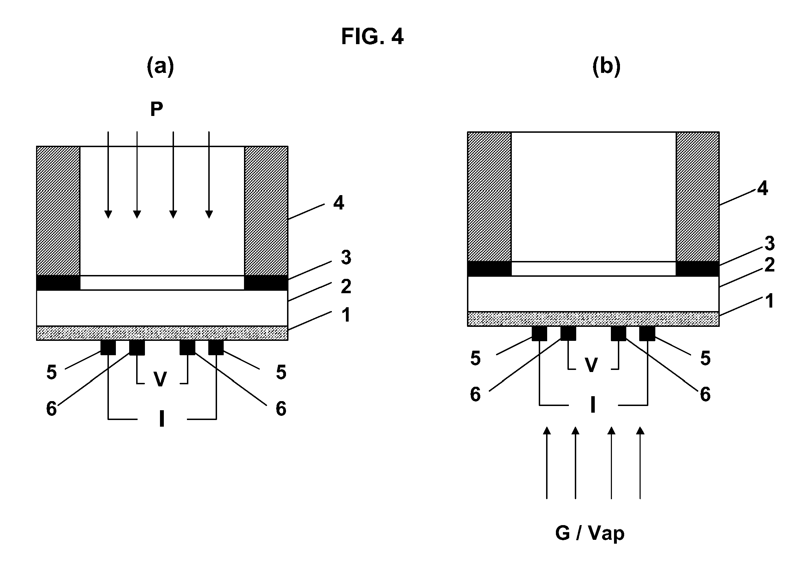

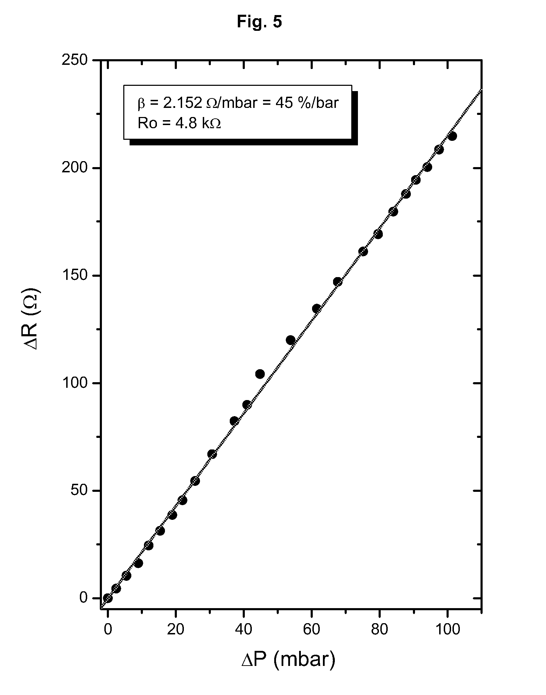

A circular sample having a diameter of 8 mm (resistance to ambient conditions of 4.8 kOhm) of the film was cut and mounted on a glass tube with epoxy. The dependence of the resistance with pressure was measured using the four-point dc method with four platinum cables having a diameter of 20 microns (Figure 4). The resistance of the film demonstrates a high piezoelectric effect (Figure 5). Within a pressure range of 0-100 mbar, resistance increased linearly at a speed of 45% bar⁻¹.

### Example 2: Gas sensing device formed of a layer of (BET-TTF)₂IₓBr₃₋ₓ [BET-TTF: bis(ethylenthio-tetrathiafulvalene)] over polycarbonate.

A mixture of 0.98 g of poly-(bisphenol-A-carbonate) (PC) and 0.02 g of bis(ethylenthio)-tetrathiafulvalene (BET-TTF) was prepared in 50 ml of 1.2-dichlorobenzene and heated at 80°C until the total dissolution thereof. The resulting solution was deposited on a glass surface at 130°C, allowing the solvent to evaporate, thereby obtaining a film having a thickness of 25 microns.

### Example 2a

The surface of said film was exposed to the vapours of a dissolution saturated with iodine bromide in methylene chloride for five minutes. This gave rise to the formation of a semiconductive superficial layer having a thickness of 1.5 microns formed by (BET-TTF)₂IₓBr₃₋ₓ salt micro- and nanocrystals.

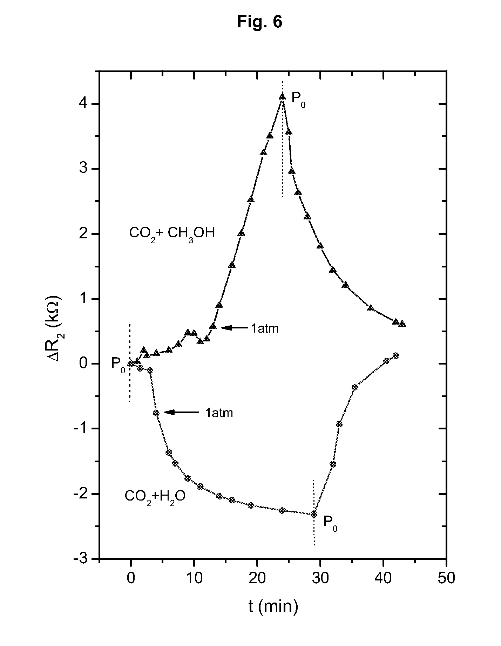

A circular sample having a diameter of 10 mm (resistance to ambient conditions of 4.3 kOhm) of the film was cut and mounted on a glass tube with epoxy. In order to activate the gas-sensing properties, the sensor was placed in a vacuum chamber to eliminate the possible gases or impurities that could be absorbed in the film. The dependence of the resistance with the presence of a CO₂-bearing gas that contained water or methanol was measured using the four-point dc method with four platinum cables having a diameter of 20 microns (Figure 4). The response of the sensor is shown in Figure 6, where we can observe that the sensor is very sensitive and responds to the two gas mixtures in a selective manner: resistance increases significantly when the CO₂ contains methanol and diminishes when it contains water. Upon producing a vacuum the initial value of the resistance is recovered.

### Example 2b

Said film surface was exposed to the vapours of a dissolution saturated with iodine bromide in methylene chloride for six minutes. This gave rise to the formation of a semiconductive superficial layer having a thickness of 1.5 microns formed of (BET-TTF)₂IₓBr₃₋ₓ salt micro- and nanocrystals.

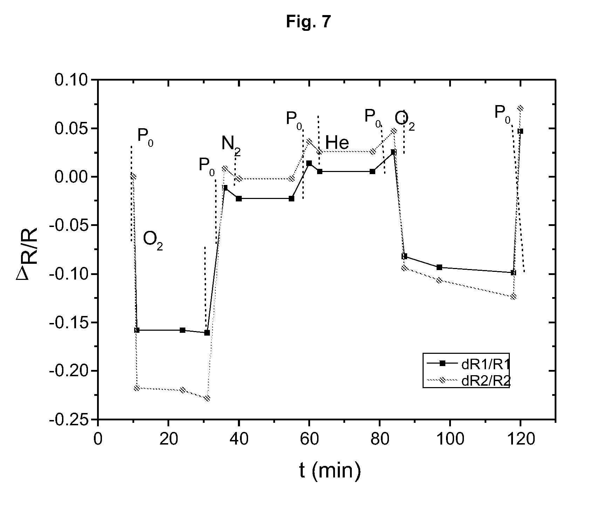

A circular sample having a diameter of 10 mm (resistance to ambient conditions of 3.0 kOhm) of the film was cut and mounted on a glass tube with epoxy. In order to activate the gas-sensing properties, the sensor was placed in a vacuum chamber to eliminate the possible gases or impurities that could be absorbed in the film. The film was exposed to O₂, N₂ and He gases and the electric response was measured using the four-point dc method with four platinum cables having a diameter of 20 microns. The response of the sensor device is shown in Figure 7. We can observe that the sensor reacts differently to the presence of these gases: in a vacuum, N₂ or He atmosphere the resistance of the organic conductor increases with respect to the resistance in an O₂ atmosphere. After producing the vacuum, the initial value of the resistance is recovered.

### Example 2c

Said film surface was exposed to the vapours of a dissolution saturated with iodine bromide in methylene chloride for eight minutes. This gave rise to the formation of a semiconductive superficial layer having a thickness of 2 microns formed of (BET-TTF)₂IₓBr₃₋ₓ salt micro- and nanocrystals.

A circular sample having a diameter of 10 mm (resistance to ambient conditions of 2.6 kOhm) of the film was cut and mounted on a glass tube with epoxy. In order to activate the gas-sensing properties, the sensor was placed in a vacuum chamber to eliminate the possible gases or impurities that could be absorbed in the film. The film was exposed to O₂, N₂ and He gases and the electric response was measured using the four-point dc method with four platinum cables having a diameter of 20 microns. The response of the sensor device is shown in Figure 7. We can observe that the film is very sensitive to the gases to which it is exposed, although the response is lower than in the case of the film described in Example 2b. After producing the vacuum, the initial value of the resistance was recovered.

### Example 2d

Said film surface was exposed to the vapours of a dissolution of 1 mg/ml of iodine bromide in methylene chloride for two minutes. This gave rise to the formation of a semiconductive superficial layer having a thickness of 1.5 microns formed of (BET-TTF)₂IₓBr₃₋ₓ salt micro- and nanocrystals.

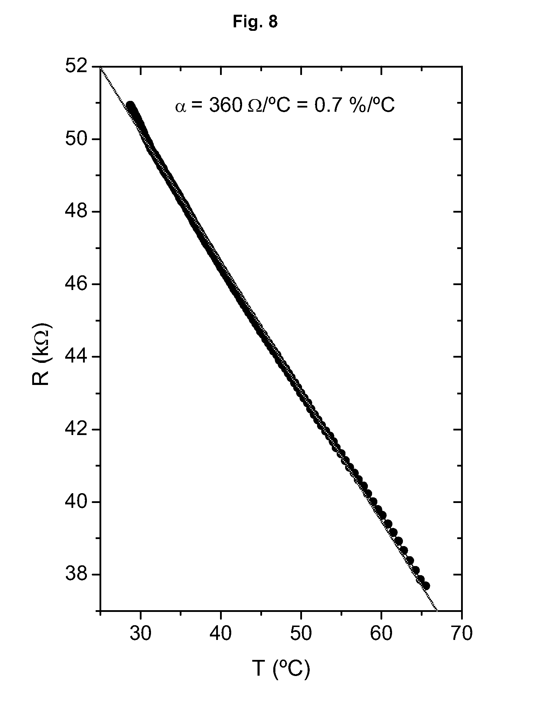

A 2x1 mm² rectangular sample of the film was cut and the dependence of the resistance with the temperature was measured using the four-point dc method with four platinum cables having a diameter of 20 microns. The resistance of the film reveals a high effect with the temperature (Figure 8). Within a temperature range of 28-65°C resistance diminishes linearly at a speed of 7% °C⁻¹.

### Trials and results

The results (see Table 1, Table 2 and Table 3) of the trials conducted on an organic sensor device in accordance with the present invention are included below:

**Table 1**

| N | ΔP (mbar) | ΔR (Ohm) | ΔR/R₀ (%) |
|---|---|---|---|
| 1 | 0 | 0 | 0 |
| 2 | 2.5 | 4.5 | 0.09 |
| 3 | 5.5 | 10.4 | 0.22 |
| 4 | 9.0 | 16.2 | 0.34 |
| 5 | 12.0 | 24.4 | 0.51 |
| 6 | 15.4 | 31.3 | 0.65 |
| 7 | 19.0 | 38.7 | 0.80 |
| 8 | 22.0 | 45.5 | 0.95 |
| 9 | 25.7 | 54.5 | 1.14 |
| 10 | 30.7 | 66.9 | 1,39 |
| 11 | 37.3 | 82.3 | 1.71 |
| 12 | 41.0 | 89.9 | 1.87 |
| 13 | 44.8 | 104.2 | 2.17 |
| 14 | 53.8 | 119.9 | 2.50 |
| 15 | 61.5 | 134.6 | 2.80 |
| 16 | 67.7 | 147.1 | 3.06 |
| 17 | 75.1 | 161.2 | 3.36 |
| 18 | 79.5 | 169.2 | 3.51 |
| 19 | 84.0 | 179.6 | 3.74 |
| 20 | 87.7 | 187.9 | 3.91 |
| 21 | 90.6 | 194.4 | 4.05 |
| 22 | 94.0 | 200.4 | 4.18 |
| 23 | 97.5 | 208.6 | 4.35 |
| 24 | 101.3 | 214.9 | 4.48 |
| 25 | 93.9 | 207.5 | 4.32 |
| 26 | 90.0 | 200.6 | 4.18 |
| 27 | 86.0 | 193.0 | 4.02 |
| 28 | 82.2 | 183.5 | 3.82 |
| 29 | 77.8 | 176.1 | 3.66 |
| 30 | 70.1 | 161.4 | 3.36 |
| 31 | 52.5 | 123.9 | 2.58 |
| 32 | 27.0 | 67.7 | 1.41 |
| 33 | 20.6 | 54.3 | 1.13 |
| 34 | 13.0 | 34.3 | 0.71 |
| 35 | 0 | 0 | 0 |
| Piezosensitivity κ = ΔR/ΔP R₀; κ ≅ 45% | | | |

Said Table 1 shows the results obtained in a sensor device based on a layer of organic material (BEDT-TTF)₂|₃, where ΔP=P-P₀ is the pressure differential between the applied pressure P and the ambient pressure P₀; and where ΔR=R(P)-R₀ is the resistance differential between the resistance to an applied pressure R(P) and the resistance to the ambient pressure R₀.

**Table 2**

| Gas | ΔR/R₀ |
|---|---|
| Nitrogen | -0.01 |
| Helium | -0.01 |
| CO₂ | 0.01 |
| **CO₂+H₂O** | **-0.13** |
| **CO₂+CH₃OH** | **0.23** |
| **Oxygen** | **-0.22** |

Said Table 2 shows a summary of the results on the sensitivity of the gases of the resistance of the layer of sensor organic material to gas changes in a sensor device based on the molecular conductor (BET-TTF)₂|ₓBr₃₋ₓ, where ΔR=R(gas)-R₀ is the resistance differential between the resistance of layer i) in the presence of a gas and the resistance R₀ of the layer i) in a vacuum (R₀=18 kOhm).

**Table 3**

| N | T | R(T) | ΔR | ΔR/R₀ |
|---|---|---|---|---|
| | (°C) | (kΩ) | (kΩ) | (%) |
| 1 | 28.000 | 51.164 | 0 | 0 |
| 2 | 29.276 | 50.681 | -0.483 | -0.94 |
| 3 | 30.552 | 50.083 | -1.081 | -2.11 |
| 4 | 31.828 | 49.559 | -1.605 | -3.14 |
| 5 | 33.103 | 49.059 | -2.105 | -4.11 |
| 6 | 34.379 | 48.587 | -2.577 | -5.04 |
| 7 | 35.655 | 48.111 | -3.053 | -5.97 |
| 8 | 36.931 | 47.607 | -3.557 | -6.95 |
| 9 | 38.207 | 47.119 | -4.045 | -7.91 |
| 10 | 39.483 | 46.665 | -4.499 | -8.79 |
| 11 | 40.759 | 46.206 | -4.958 | -9.69 |
| 12 | 42.034 | 45.747 | -5.417 | -10.59 |
| 13 | 43.310 | 45.287 | -5.877 | -11.49 |
| 14 | 44.586 | 44.848 | -6.316 | -12.34 |
| 15 | 45.862 | 44.401 | -6.763 | -13.22 |
| 16 | 47.138 | 43.980 | -7.184 | -14.04 |
| 17 | 48.414 | 43.547 | -7.617 | -14.89 |
| 18 | 49.690 | 43.106 | -8.058 | -15.75 |
| 19 | 50.966 | 42.660 | -8.504 | -16.62 |
| 20 | 52.241 | 42.212 | -8.952 | -17.50 |
| 21 | 53.517 | 41.826 | -9.338 | -18.25 |
| 22 | 54.793 | 41.379 | -9.785 | -19.13 |
| 23 | 56.069 | 40.938 | -10.226 | -19.99 |
| 24 | 57.345 | 40.551 | -10.613 | -20.74 |
| 25 | 58.621 | 40.118 | -11.046 | -21.59 |
| 26 | 59.897 | 39.691 | -11.473 | -22.42 |
| 27 | 61.172 | 39.258 | -11.906 | -23.27 |
| 28 | 62.448 | 38.788 | -12.376 | -24.19 |
| 29 | 63.724 | 38.297 | -12.867 | -25.15 |
| 30 | 65.000 | 37.820 | -13.344 | -26.08 |

Said Table 3 shows the results obtained in a sensor device based on a layer of organic material (BET)₂IₓBr₃₋ₓ, where ΔR = R(T) - R₀ is the resistance differential between resistance at an applied temperature and resistance at ambient temperature.

## Claims

1. Organic sensor device **characterised in that** it consists of:
i) a layer of organic material sensitive to changes in pressure, voltage, deformation, gases and/or temperature; wherein said layer of organic material is formed of at least one salt or conductive complex including a molecule A and a dopant D, said molecule A being an electron donor or acceptor organic molecule or macromolecule capable of forming a conductive salt or complex, which without doping is not conductive, and said dopant D being a compound that is an electron acceptor or donor capable of forming a salt or conductive complex with the molecule or macromolecule A; and
ii) a base substrate, in close contact with said layer of organic material i), where said base substrate is inert with respect to said layer of organic material i).

2. Organic sensor device, according to claim 1, **characterised in that** said molecule or macromolecule A will be selected from among an acene, coronene, tetrathiafulvalene or tetracyanoquinodimethane derivative.

3. Organic sensor device, according to claim 2, **characterised in that** said molecule or macromolecule A is selected from among bis(ethylenthio)tetrathiafulvalene (BET-TTF) or bis(etylendithio)tetrathiafulvalene (BEDT-TTF).

4. Organic sensor device, according to claim 1, **characterised in that** said dopant D is a volatile species.

5. Organic sensor device, according to claim 4, **characterised in that** said volatile species is selected from among iodine, bromine, iodine bromide, chorine or iodine chloride.

6. Organic sensor device, according to claim 1, **characterised in that** said salt is selected from among BEDT-TTF)₂I₃ and (BET-TTF)₂IₓBr₃₋ₓ, where BET-TTF is bis(ethylenthio)tetrathiafulvalene and BEDT-TTF is bis(etylendithio)tetrathiafulvalene.

7. Organic sensor device, according to claim 1, **characterised in that** said base substrate is inert with respect to said organic layer sensitive to changes in pressure, voltage, deformation, temperature or gases, and may be inorganic, metallic, polymeric or a three-dimensional crystal.

8. Organic sensor device, according to claim 7, **characterised in that** said inorganic base substrate is selected from among silicium oxide or aluminum oxide.

9. Organic sensor device, according to claim 7, **characterised in that** said base substrate is a non-conductive organic polymer.

10. Organic sensor device, according to claim 9, **characterised in that** said base substrate is a thermoplastic polymer or elastomer.

11. Organic sensor device, according to claim 10, **characterised in that** said base substrate is selected from among polycarbonate, polymethylmetacrilate, polyethylene or polypropylene.

12. Organic sensor device, according to any of the preceding claims, **characterised in that** due to said layer of organic material i) being of (BEDT-TTF)₂I₃, said device is susceptible of application as a pressure, voltage and/or deformation sensor.

13. Organic sensor device, according to any of claims 1-11, **characterised in that** due to said layer of organic material i) being of (BET-TTF)₂IₓBr₃₋ₓ, said device is susceptible of application as a gas sensor.

14. Organic sensor device, according to any of claims 1-11, **characterised in that,** said layer of organic material i) being of (BET-TTF)₂IₓBr₃₋ₓ, said device being susceptible of application as a temperature sensor.

15. Use of the sensor device, according to claims 1 to 14, in the field of molecular electronics or plastic electronics and in the field of sensors.

16. Use of the sensor device, according to claim 15, **characterised in that** it is used in breathing masks, in medicinal devices in general, motoring, clothing or textiles and intelligent footwear.

17. Use of an organic material formed by at least one salt or conductive complex including a molecule A and a dopant D, said molecule A being an electron donor or acceptor organic molecule or macromolecule capable of forming a conductive salt or complex, which without doping is not conductive, and said dopant D being a compound that is an electron donor or acceptor capable of forming a salt or conductive complex with the molecule or macromolecule A as a sensor of changes in pressure, voltage, deformation and/or gases.

18. Use of an organic material, according to claim 17, as a sensor of changes in temperature.
